# EUROPEAN PATENT APPLICATION

(11) **EP 1 298 796 A2**
(43) Date of publication of application: **02.04.2003**
(21) Application number: 02078967.3
(22) Date of filing: 24.09.2002
(51) Int. Cl.: H03H 7/38

(54) **Antenna matching transformer and wide-band VHF- antenna**

(30) Priority: 26.09.2001 FI 20011886; 04.12.2001 FI 20012383
(71) Applicant: Cojot OY, 02201 Espoo (FI)
(72) Inventor: Haapanen, Veijo, 02110 Espoo (FI)
(74) Representative: Järveläinen, Pertti Tauno Juhani

(57) **Abstract**

An antenna matching transformer (1) for the VHF/UHF range for an antenna comprising an antenna radiator (2) and a matching transformer (4) for matching the antenna intended for transmission and reception to a desired frequency, said matching transformer comprising a coil structure with a coil core (43) of ferrite material and a pair cable (44) wound around it, which matching transformer can be matched to the desired frequency. The coil core (43) is made of a powdery material having a permeability such that, and the distance between the conductors of the cable pair is fitted to achieve a wave impedance such that, by the action of the mutual reactance of the conductors and the permeability of the coil core, the antenna is tuned to the desired frequency automatically without a special tuning element.

## Description

The present invention relates to an antenna matching transformer for an antenna comprising a radiator, a matching transformer and an interface for connecting the antenna to an antenna cable. The invention also relates to an antenna device designed especially for the VHF range and comprising a radiator, a matching transformer, an interface for connecting the antenna to an antenna cable and a mounting part.

At present, antennas designed for use in the tactical VHF range, e.g. upwards of 30 MHz, for the transmission and reception of radio signals are relatively bulky and laborious to install. In addition, they are generally use complicated transformer units formed from many capacitors, coils and other components, by means of which units the antenna radiator is adapted to function over a large frequency range, typically e.g. in the range of 30 - 90 MHz.

Such transformer units are relatively large and many components are susceptible to damage especially in the case of antennas used on moving vehicles. The transformers may additionally require preliminary adjustments, which are changed using mechanical switches and which are used to tune the antenna to a desired frequency range. The tuning may cause delays, which is why it is impossible to carry out the tuning e.g. when a widely varying frequency is used or when the same antenna is used for devices working on several different frequency bands at the same time.

E.g. specification US-A-4,631,504 discloses an antenna matching transformer by means of which e.g. a 300-Ω antenna output port can be adapted to a 75-Ω television input port automatically without any special tuning device in the UHF range. The matching transformer comprises a toroidal ferrite core with a few laps of pair cable wound around it. The permittivity of the ferrite core falls proportionally as the frequency increases in the frequency band being used. Such an antenna transformer is only applicable for use in a relatively narrow frequency band, and it is only used for signal reception.

The object of the present invention is to achieve a completely new type of wide-band antenna matching transformer designed for the VHF range and having a very simple and compact structure and allowing a very wide band matching to be achieved in the frequency range of 30 - 110 MHz, where the ratio between mean frequency and applied frequency range may be 1:2, and even higher.

Another object of the invention is to achieve a completely new type of wide-band antenna for the VHF range which is compact, works over a very wide frequency band, even in the range of 30 - 170 MHz, and which comprises an antenna matching transformer having a very simple and compact structure and enabling the antenna part to be automatically tuned to a desired frequency range without any separate tuning elements.

The matching transformer of the invention consists of a circular coil core made of a powdery material and a cable pair wound around it, in which cable mutual reactance (mutual inductance and capacitance) is generated between the conductors. In the matching transformer of the invention, a sufficiently low core material permeability is selected and the wave impedance between the conductors of the cable pair is adapted via their mutual distance so that the cables together with the coil core automatically match the antenna to the desired frequency in each case.

Correspondingly, the antenna of the invention is implemented using a matching transformer as described above, by means of which the antenna is automatically matched to the desired frequency range without any separate tuning elements.

In an embodiment of the antenna of the invention, the radiator comprises a cooling metallic tubular matching element with ferrite inside, through which a continuous radiator part is passed. Placed at the base of the radiator there may additionally be a coil that functions as a phase inversion coil at higher VHF frequencies.

Details of the features of the matching unit of the invention are presented in the claims below.

The matching transformer of the invention is compact, allowing a smaller and lighter antenna structure to be achieved as compared with prior-art solutions. In addition, the matching transformer tunes the antenna completely automatically, so there is no need for manual tuning. Moreover, the matching transformer of the invention is very reliable, and it is not sensitive to mechanical stress, such as the vibration of rolling stock.

An antenna structure implemented according to the invention will be smaller and lighter than prior-art solutions. In addition, the frequency range is very wide in relation to the size of the antenna. Using an antenna provided with a matching transformer according to the invention, it is possible to transmit at a high transmission power (even 100 W) if necessary. Moreover, the antenna can be fitted with a simple magnetic mounting element, allowing the antenna to be easily mounted on and dismounted from e.g. the roof of a vehicle.

In the following, the invention will be described in detail by the aid of a few examples with reference to the attached drawings, wherein
Fig. 1 presents a wide-band antenna provided with a matching transformer according to the invention, in partial longitudinal section taken at the level of the matching unit,
Fig. 2 presents a more detailed view of the matching transformer of the invention as seen from above, and
Fig. 3 presents another wide-band antenna provided with a matching transformer according to the invention, in partial longitudinal section taken at the level of the matching unit.

### Example 1

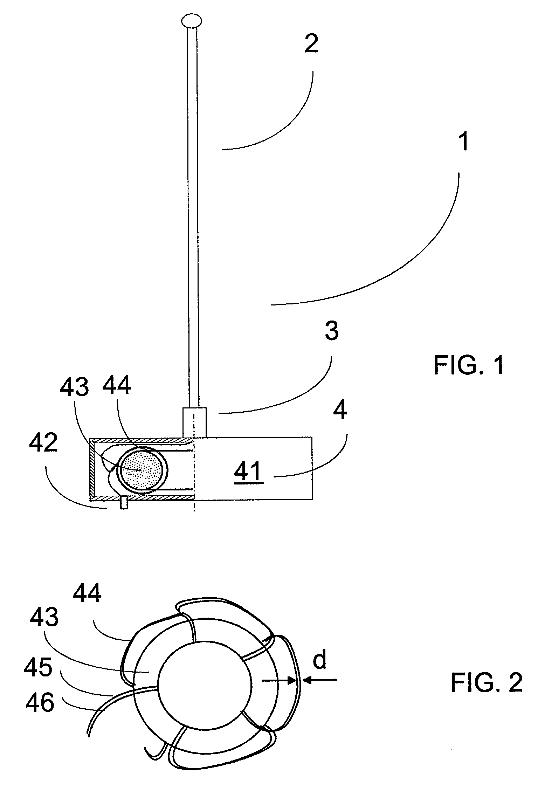

Fig. 1 presents a wide-band antenna 1 designed for a VHF range of 30 - 110 MHz and applicable for use e.g. on a vehicle. It comprises a whip-like radiator 2 whose length typically equals one fourth of the mean-frequency wavelength, a mounting element 3 and a matching transformer 4 according to the invention fitted under it to match the antenna for operation in the frequency range in question.

The matching transformer is provided with a casing 41, the electric circuit being fitted inside it. Provided at the lower edge of the casing is a connector 42 for connection of the unit to radio equipment via an antenna cable for transmission and reception in the VHF range.

In the matching transformer of the invention, the electric circuit consists of a toroidal coil core 43 made of a powdery ferro-alloy. Wound around the core 43 is a cable pair 44, consisting of e.g. five laps distributed with even distances on the circumference of the core to form a toroidal structure. The conductors 45, 46 of the cable pair 44 are connected to the antenna connector 42 and to the radiator 2.

The coil core 43 consists of small ferroparticles agglomerated by a suitable cement to form a toroidal core. The properties of the core are determined according to the size and density of the core and the ferro-alloy used. Such a core will not be easily saturated, and it has a high temperature stability and Q. In addition, it has a low permeability µ (below 75). In the matching transformer of the invention, the core typically has a diameter of about 30 mm and a thickness of 10 mm. The distance d between the conductors 45 and 46 of the cable is so selected that the wave impedance Z of the cable will be about 100 Ω.

The operation of the matching transformer is such that, in the conductors of the pair cable, mutual reactance is generated, by means of which the conductors together with the coil core tune the radiator to the desired frequency automatically so that the antenna forms the impedance, typically 50 Ω, required by the antenna interface.

### Example 2

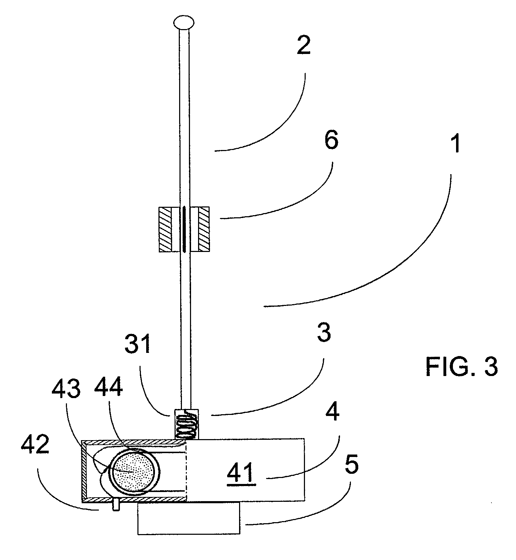

Fig. 3 presents another wide-band antenna 1 for the VHF range of 30 - 170 MHz, applicable for use e.g. on a vehicle and comprising a whip-like radiator 2 of a length typically equal to a quarter of the wavelength corresponding to a 45 MHz frequency, e.g. 1400 mm, its base part 3, a matching transformer 4 as described in example 1 fitted under it, by means of which the antenna is matched for operation in the frequency range in question, and a magnetic mount 5 for attachment, by means of which the antenna can be easily and quickly mounted on the roof of a vehicle.

The base part 3 consists of a radiator coil 31, which works at a frequency of e.g. 150 MHz as a phase inversion coil that converts the antenna into a 5/8 wavelength antenna at 150 MHz frequencies.

Disposed at about the middle part of the radiator 2 is additionally a ferrite matching tube 6, which in the case of a 1400-mm radiator may have a length of 50 mm, the radiator extending through this tube. By the action of the matching tube 6, the matching and Q of the radiator are so modified that the impedance will be about 200 Ω in the 30 ... 170 MHz range. Thus, the radiator is very well matched over a wide frequency range by the matching transformer in the magnetic mount.

It is obvious to the person skilled in the art that different embodiments of the invention are not limited to the example described above, but that they may be varied within the scope of the claims presented below.

## Claims

1. Antenna matching transformer (1) for the VHF/UHF range for an antenna comprising an antenna radiator (2) and a matching transformer (4) for matching the antenna intended for transmission and reception to a desired frequency, said matching transformer comprising a coil structure with a coil core (43) of ferrite material and a pair cable (44) wound around it, which matching transformer can be matched to the desired frequency, **characterized in that**
the coil core (43) is made of a powdery material having a permeability such that, and the distance (d) between the conductors of the cable pair has been fitted to achieve a wave impedance (Z) such that, by the action of the mutual reactance of the conductors and the permeability of the coil core, the antenna is tuned to the desired frequency automatically without a special tuning element.

2. Matching transformer according to claim 1, **characterized in that** the cable pair is wound around the core in one plane, and the number of laps is below ten, preferably 4 - 6.

3. Matching transformer according to claim 1, **characterized in that** the coil core has a permeability (µ) below 100, especially below 75.

4. Matching transformer according to claim 1, **characterized in that** the distance (d) between the conductors (45, 46) of the cable is such that the cable has a wave impedance (Z) in the range of 50 - 150 Ω, e.g. 100 Ω.

5. Antenna (1) designed for transmission and reception in the VHF/UHF range, comprising an antenna radiator (2) and a matching transformer (4) for matching the antenna to a desired frequency, said matching transformer comprising a coil structure with a coil core (43) of ferrite material and a pair cable (44) wound around it, which matching transformer can be matched to the desired frequency, **characterized in that** the coil core (43) is made of a powdery material having a permeability such that, and the distance (d) between the conductors of the cable pair has been fitted to achieve a wave impedance (Z) such that, by the action of the mutual reactance of the conductors and the permeability of the coil core, the antenna is tuned to the desired frequency automatically without a special tuning element.

6. Antenna according to claim 5, **characterized in that** the it comprises a metallic tubular matching element (6) placed at the middle of the radiator, through which matching element the radiator is passed and which serves to change the matching of the radiator.

7. Antenna according to claim 5, **characterized in that** the coil core is of toroidal construction.

8. Antenna according to claim 5, in which the radiator comprises a base part (3), **characterized in that** the base part of the radiator is provided with a spiral coil (31) that functions as a phase inversion coil at certain frequencies.
